# EUROPEAN PATENT APPLICATION

(11) **EP 4 822 738 A1**
(43) Date of publication of application: **14.10.2026**
(21) Application number: 23960757.5
(22) Date of filing: 05.12.2023
(51) Int. Cl.: H01L 21/02, G09F 9/33, G09F 9/00, H10H 20/857

(54) **TRANSFER METHOD, TRANSFER UNIT, RELEASE PLATE, RELEASE PLATE PRECURSOR SUBSTRATE, METHOD FOR MANUFACTURING DISPLAY DEVICE, AND METHOD FOR MANUFACTURING MOUNTING BOARD**

(71) Applicant: SHIN-ETSU CHEMICAL CO., LTD., Tokyo 100-0005 (JP); Shin-Etsu Engineering Co., Ltd., Tokyo 101-0054 (JP)
(72) Inventor: OGAWA, Yoshinori, Tokyo 100-0005 (JP); KIMURA, Shinji, Annaka-shi, Gunma 379-0224 (JP); SUNAGA, Seijiro, Tokyo 100-0005 (JP); SUZUKI, Tomoya, Annaka-shi, Gunma 379-0127 (JP); KAMEKAWA, Rin, Annaka-shi, Gunma 379-0127 (JP); UEMORI, Nobutaka, Yokohama-shi, Kanagawa 234-0053 (JP); USAMI, Taketo, Yokohama-shi, Kanagawa 234-0053 (JP); YAMAOKA, Hiroshi, Yokohama-shi, Kanagawa 234-0053 (JP)
(74) Representative: Meissner Bolte Partnerschaft mbB
(86) International application number: PCT/JP2023/043507
(87) International publication number: WO 2025/120744

(57) **Abstract**

The present invention is a transfer method for transferring a structure to a transfer destination including: providing a release plate including a base member, a resin layer provided on the base member, and a structure held on a surface of the resin layer opposite the base member, in which a holding thickness of a portion of the resin layer which is positioned between the base member and the structure is such that a transmittance for a transfer laser is 50% or more; and transferring the structure from the release plate to the transfer destination by causing the transfer laser to be incident on the base member from a surface of the base member opposite the resin layer with such energy density that at least a portion of the resin layer remains on the base member. Thus, a transfer method capable of reducing residues deriving from the resin layer (a holding layer) on the structure after transfer can be provided.

## Description

### TECHNICAL FIELD

The present invention relates to: a transfer method; a transfer unit; a release plate; a release-plate precursor substrate; a method for manufacturing a display apparatus; and a method for manufacturing a mounted board.

### BACKGROUND ART

Recently, as a means for assembling electrical/electronic application products using a semiconductor device accompanying miniaturization of the semiconductor device, a microstructure-transfer (repositioning) technology using adhesive resin has attracted attention. In particular, the technology of manufacturing LED displays for applications of signages, TVs, medical uses, onboard uses, smartphones, and the like by transferring (repositioning) tens of thousands of mini LEDs (LED devices having a short side of 100 µm or more to several 100 µm) or micro LEDs (LED devices having a short side of 100 µm or less, 50 µm or less further) at once is under active development.

So far, a method for repositioning a microstructure such as a micro LED using a silicone adhesive cured product as a donor substrate or a stamp material for transfer, and a method for mounting the device onto a circuit board have been developed (for example, Patent Document 1).

In addition, a technology capable of mitigating an impact during transfer, and transferring a semiconductor chip with high accuracy has been also proposed (for example, Patent Document 2).

### CITATION LIST

### PATENT LITERATURE

Patent Document 1: JP 2021-34610 A
Patent Document 2: JP 2019-67892 A

### NON PATENT LITERATURE

Non Patent Document 1: Kristin M. Charipar et al., "Use of an Elastomeric Donor for LIFT of Metal Foils", Journal of Laser Micro/Nanoenginerring, Vol. 13, No. 2, 2018.

### SUMMARY OF INVENTION

### TECHNICAL PROBLEM

Now, as a technology of transferring a structure by a laser, there is a technology of transferring an object to be transferred by virtue of a laser-induced phenomenon such as laser ablation. Of such a technology, a technology of moving an object to be transferred in a laser irradiation direction is referred to as LIFT (Laser-Induced Forward Transfer) (for example, Non Patent Document 1). Conversely, a method in which an object to be transferred returns in the laser irradiation direction is referred to as LIBT (Laser-Induced Back Transfer).

In conventional LIFT, a release plate including a substrate and a holding layer that is formed on the substrate and holds a structure is used, and separation (transfer) is performed from an interface of the substrate and the holding layer of the release plate by laser ablation. According to such a method, it is possible to transfer the structure to a transfer destination with a certain degree of accuracy.

However, in the conventional LIFT, it has been examined to surely cause ablation in order to ensure transfer of the structure. Therefore, a resin layer on the release plate is strongly ablated, resulting in a problem that a lot of residues deriving from the resin layer remain on the structure after transfer.

The present invention is implemented in order to solve the above problem, and an object is to provide: a transfer method capable of reducing residues deriving from a resin layer (a holding layer) on a structure after transfer; a transfer unit capable of transferring a structure with reduced residues to a transfer destination; a release plate capable of transferring a structure with reduced residues; a release-plate precursor substrate capable of providing a release plate capable of transferring a structure with reduced residues; a method for manufacturing a display apparatus, capable of manufacturing the display apparatus with structures with reduced residues arranged on a wiring board; and a method for manufacturing a mounted board, capable of manufacturing the mounted board with structures with reduced residues arranged on a wiring board.

### SOLUTION TO PROBLEM

To solve the problem, the present invention provides, as a transfer method of a first embodiment, a transfer method for transferring a structure to a transfer destination, the transfer method comprising:
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the transfer destination by causing the transfer laser to be incident on the base member from a surface of the base member opposite the resin layer with such energy density that at least a portion of the resin layer remains on the base member.

According to such a transfer method of the first embodiment, it is possible to reduce residues deriving from a resin layer (a holding layer) on a structure after transfer.

The holding thickness of the resin layer is preferably such that the transmittance for the transfer laser is 70% or more.

By using the resin layer having such a holding thickness that the transmittance for the transfer laser is 70% or more, it is possible to reduce residues deriving from the resin layer (the holding layer) on the structure after transfer.

The holding thickness of the resin layer may be 0.1 µm or less.

For example, it is possible to set the holding thickness of the resin layer to 0.1 µm or less.

The holding thickness of the resin layer is preferably 0.06 µm or less.

The holding thickness of the resin layer is preferably set to 0.06 µm or less.

The resin layer in which a region other than a region where the structure is provided includes a portion thicker than the holding thickness may be used.

In the resin layer, the holding thickness of the portion of the resin layer positioned between the base member and the structure may be such that the transmittance for the transfer laser is 50% or more, and the other portion may be thicker than the holding thickness.

For example, the thickness of the thick portion may be set to more than 0.1 µm and 0.4 µm or less.

The thickness of the thick portion is not limited in particular, but can be set to more than 0.1 µm and 0.4 µm or less for example.

For example, at least a portion of the resin layer may be thermally decomposed on an interface where the structure and the resin layer are in contact with each other, thereby transferring the structure from the release plate to the transfer destination.

For example, it is possible to thermally decompose at least a portion of the resin layer on an interface where the structure and the resin layer are in contact with each other, thereby transferring the structure from the release plate to the transfer destination.

In this case, the resin layer may be thermally decomposed on the interface by heat generation at a surface of the structure in contact with the resin layer to a thermal decomposition temperature of the resin layer or higher by the transfer laser transmitted through the base member and the resin layer.

The resin layer may be thermally decomposed not by absorption of the transfer laser but by heat generation at the surface of the structure in contact with the resin layer to the thermal decomposition temperature of the resin layer or higher.

A thermal decomposition temperature of a constituent material of the surface of the structure in contact with the resin layer is preferably higher than the thermal decomposition temperature of the resin layer.

According to such a structure, it is possible to perform transfer to a transfer destination while preventing degradation.

The thermal decomposition temperature of the constituent material of the surface of the structure in contact with the resin layer is preferably higher than the thermal decomposition temperature of the resin layer by 200°C or more.

Such a structure can be transfer to a transferred destination while more reliably preventing degradation.

For example, the resin layer may contain polyimide or benzocyclobutene resin.

Though not limited in particular, for example, it is possible to use the resin layer containing polyimide or benzocyclobutene resin.

For example, the surface of the structure in contact with the resin layer may contain gallium nitride or gallium phosphide.

The constituent material of the structure is not limited in particular, however, it is possible to transfer the structure in which the surface in contact with the resin layer contains gallium nitride or gallium phosphide, for example.

For example, the resin layer may contain polyimide and the surface of the structure in contact with the resin layer may contain gallium nitride.

For example, it is possible to use the resin layer containing polyimide and to transfer the structure in which the surface in contact with the resin layer contains gallium nitride.

Alternatively, the resin layer may contain polyimide and the surface of the structure in contact with the resin layer may contain gallium phosphide.

For example, it is also possible to use the resin layer containing polyimide and to transfer the structure in which the surface in contact with the resin layer contains gallium phosphide.

Alternatively, the resin layer may contain benzocyclobutene resin and the surface of the structure in contact with the resin layer may contain gallium phosphide.

For example, it is also possible to use the resin layer containing benzocyclobutene resin and to transfer the structure in which the surface in contact with the resin layer contains gallium phosphide.

For example, the transmittance for the transfer laser of the base member may be 90% or more.

The transmittance for the transfer laser of the base member is not limited in particular, but can be set to 90% or more, for example.

The transfer laser may be an excimer laser having a wavelength of 248 nm, for example.

The wavelength of the transfer laser is not limited in particular, however, it is possible to use the excimer laser having the wavelength of 248 nm, for example.

In addition, the present invention provides, as a transfer method of a second embodiment, a transfer method for transferring a structure to a transfer destination, the transfer method comprising:
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the transfer destination by causing a transfer laser to be incident on the base member from a surface of the base member opposite the resin layer with such energy density that at least a portion of the resin layer remains on the base member.

According to such a transfer method of the second embodiment as well, it is possible to reduce residues deriving from the resin layer (the holding layer) on the structure after transfer.

For example, the transmittance for the transfer laser of the base member may be 90% or more.

The transmittance for the transfer laser of the base member is not limited in particular, but can be set to 90% or more, for example.

Further, the present invention provides, as a transfer method of a third embodiment, a transfer method for transferring a structure to a transfer destination, the transfer method comprising:
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring of the structure from the release plate to the transfer destination.

According to such a transfer method of the third embodiment as well, it is possible to reduce residues deriving from the resin layer (the holding layer) on the structure after transfer.

In addition, the present invention provides, as a transfer unit of a first embodiment, a transfer unit for transferring a structure to a transfer destination, the transfer unit comprising:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

According to such a transfer unit of the first embodiment, it is possible to reduce residues deriving from the resin layer (the holding layer) on the structure after transfer.

The holding thickness of the resin layer is preferably such that the transmittance for the transfer laser is 70% or more.

According to the transfer unit including the resin layer having such a holding thickness that the transmittance for the transfer laser is 70% or more, it is possible to transfer the structure to the transfer destination with higher accuracy.

The holding thickness of the resin layer may be 0.1 µm or less.

For example, it is possible to set the holding thickness of the resin layer to 0.1 µm or less.

The holding thickness of the resin layer is preferably 0.06 µm or less.

The holding thickness of the resin layer is preferably set to 0.06 µm or less.

In the resin layer, a region other than a region where the structure is provided may include a portion thicker than the holding thickness.

In the resin layer, the holding thickness of the portion of the resin layer positioned between the base member and the structure may be such that the transmittance for the transfer laser is 50% or more, and the other portion may be thicker than the holding thickness.

For example, the thickness of the thick portion may be more than 0.1 µm and 0.4 µm or less.

The thickness of the thick portion is not limited in particular, but can be set to more than 0.1 µm and 0.4 µm or less for example.

In the transfer unit of the present invention, for example, at least a portion of the resin layer may be thermally decomposed on an interface where the structure and the resin layer are in contact with each other, thereby transferring the structure from the release plate to the transfer destination.

In the transfer unit of the present invention, for example, it is possible to thermally decompose at least a portion of the resin layer on an interface where the structure and the resin layer are in contact each other, and to transfer the structure from the release plate to the transfer destination.

In this case, the resin layer may be thermally decomposed on the interface by heat generation at a surface of the structure in contact with the resin layer to a thermal decomposition temperature of the resin layer or higher by virtue of the transfer laser transmitted through the base member and the resin layer.

The resin layer may be thermally decomposed not by absorption of the transfer laser but by heating the surface of the structure in contact with the resin layer to the thermal decomposition temperature of the resin layer or higher.

A thermal decomposition temperature of a constituent material of the surface of the structure in contact with the resin layer is preferably higher than the thermal decomposition temperature of the resin layer.

According to such a transfer unit, it is possible to transfer the structure to the transfer destination while preventing the degradation.

The thermal decomposition temperature of the constituent material of the surface of the structure in contact with the resin layer is preferably higher than the thermal decomposition temperature of the resin layer by 200°C or more.

According to such a transfer unit, it is possible to transfer the structure to the transfer destination while more reliably preventing the degradation.

For example, the resin layer may contain polyimide or benzocyclobutene resin.

Though not limited in particular, for example, it is possible to use the resin layer containing polyimide or benzocyclobutene resin.

For example, the surface of the structure in contact with the resin layer may contain gallium nitride or gallium phosphide.

The constituent material of the structure is not limited in particular, however, it is possible to include the structure in which the surface in contact with the resin layer contains gallium nitride or gallium phosphide, for example.

For example, the resin layer may contain polyimide and the surface of the structure in contact with the resin layer may contain gallium nitride.

For example, it is possible to include the resin layer containing polyimide and the structure in which the surface in contact with the resin layer contains gallium nitride.

Alternatively, the resin layer may contain benzocyclobutene resin and the surface of the structure in contact with the resin layer may contain gallium phosphide.

For example, it is also possible to include the resin layer containing benzocyclobutene resin and the structure in which the surface in contact with the resin layer contains gallium phosphide.

Alternatively, the resin layer may contain polyimide and the surface of the structure in contact with the resin layer may contain gallium phosphide.

For example, it is also possible to include the resin layer containing polyimide and the structure in which the surface in contact with the resin layer contains gallium phosphide.

For example, the transmittance for the transfer laser of the base member may be 90% or more.

The transmittance for the transfer laser of the base member is not limited in particular, but can be set to 90% or more, for example.

The light source may oscillate an excimer laser having a wavelength of 248 nm, for example.

The wavelength of the transfer laser is not limited in particular, however, it is possible to use the excimer laser having the wavelength of 248 nm, for example.

Further, the present invention provides, as a transfer unit of a second embodiment, a transfer unit for transferring a structure to a transfer destination, the transfer unit comprising:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is 0.1 µm or less;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

According to such a transfer unit of the second embodiment as well, it is possible to reduce residues deriving from the resin layer (the holding layer) on the structure after transfer.

For example, the transmittance for the transfer laser of the base member may be 90% or more.

The transmittance for the transfer laser of the base member is not limited in particular, but can be set to 90% or more, for example.

In addition, the present invention provides, as a transfer unit of a third embodiment, a transfer unit for transferring a structure to a transfer destination, the transfer method comprising:
a light source that oscillates a transfer laser;
a release plate including a base member, a resin layer provided on the base member, and a structure held on a surface of the resin layer opposite the base member; and
a controller configured to control oscillation of the transfer laser by the light source so that the transfer laser is to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the transfer destination.

According to such a transfer unit of the third embodiment as well, it is possible to reduce residues deriving from the resin layer (the holding layer) on the structure after transfer.

Further, the present invention provides, as a release plate of a first embodiment, a release plate to be used for transferring a structure to a transfer destination by a transfer laser, the release plate comprising:
a base member;
a resin layer provided on the base member; and
a structure held on a surface of the resin layer opposite the base member, wherein
a holding thickness of a portion of the resin layer which is positioned between the base member and the structure is such that a transmittance for the transfer laser is 50% or more.

According to such a release plate of the first embodiment, it is possible to reduce residues deriving from the resin layer (the holding layer) on the structure after transfer.

In addition, the present invention provides, as a release plate of a second embodiment, a release plate to be used for transferring a structure to a transfer destination by a transfer laser, the release plate comprising:
a base member;
a resin layer provided on the base member; and
a structure held on a surface of the resin layer opposite the base member, wherein
a holding thickness of a portion of the resin layer which is positioned between the base member and the structure is 0.1 µm or less.

According to such a release plate of the second embodiment as well, it is possible to reduce residues deriving from the resin layer (the holding layer) on the structure after transfer.

Further, the present invention provides a release-plate precursor substrate to be used for manufacturing a release plate for transferring a structure to a transfer destination by a transfer laser, the release-plate precursor substrate comprising:
a base member; and
a resin layer provided on the base member, wherein
a thickness of the resin layer is 0.4 µm or less.

When such a release-plate precursor substrate is used, it is possible to reduce residues deriving from the resin layer (the holding layer) on the structure after transfer.

Furthermore, the present invention provides, as a method for manufacturing a display apparatus of a first embodiment, a method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

According to such a method for manufacturing the display apparatus of the first embodiment, it is possible to manufacture the display apparatus wherein the structures with reduced residues are arranged on the wiring board.

In addition, the present invention provides, as a method for manufacturing a display apparatus of a second embodiment, a method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

According to such a method for manufacturing the display apparatus of the second embodiment as well, it is possible to manufacture the display apparatus wherein the structures with reduced residues are arranged on the wiring board.

Further, the present invention provides, as a method for manufacturing a display apparatus of a third embodiment, a method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

According to such a method for manufacturing the display apparatus of the third embodiment as well, it is possible to manufacture the display apparatus wherein the structures with reduced residues are arranged on the wiring board.

In addition, the present invention provides, as a method for manufacturing a mounted board of a first embodiment, a method for manufacturing a mounted board, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

According to such a method for manufacturing the mounted board of the first embodiment, it is possible to manufacture the mounted board wherein the structures with reduced residues are arranged on the wiring board.

Further, the present invention provides, as a method for manufacturing a mounted board according to a second embodiment, a method for manufacturing a mounted board, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

According to such a method for manufacturing the mounted board of the second embodiment as well, it is possible to manufacture the mounted board wherein the structures with reduced residues are arranged on the wiring board.

Furthermore, the present invention provides, as a method for manufacturing a mounted board according to a third embodiment, a method for manufacturing a mounted board, wherein a structure is transferred to a wiring board, the method comprising:
providing the wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

According to such a method for manufacturing the mounted board of the third embodiment as well, it is possible to manufacture the mounted board wherein the structures with reduced residues are arranged on the wiring board.

### BRIEF DESCRIPTION OF DRAWINGS

[FIG. 1] FIG. 1 is a schematic illustration showing an example of a transfer unit of the present invention;
[FIG. 2] FIG. 2 is a schematic enlarged sectional view of a portion of a release plate shown in FIG. 1;
[FIG. 3] FIG. 3 is a schematic enlarged sectional view showing a portion of an example of a transfer method of the present invention; and
[FIG. 4] FIG. 4 is a schematic sectional view showing a portion of another example of the transfer method of the present invention.

### DESCRIPTION OF EMBODIMENTS

As described above, it has been demanded to develop a transfer method in which residues on a structure after transfer is reduced.

The present inventors completed the present invention by finding that a structure can be transferred to a transfer destination while reducing residues deriving from a resin layer (a holding layer) on the structure after transfer by virtue of using a release plate in which a holding thickness of a portion of a resin layer which is positioned between a base member and the structure is such that a transmittance for a transfer laser is 50% or more or a release plate in which the holding thickness of the portion of the resin layer which is positioned between the base member and the structure is 0.1 µm or less, and causing the transfer laser to be incident on the base member from a surface of the base member opposite the resin layer with such energy density that at least a portion of the resin layer remains on the base member, or causing the transfer laser to be incident on the base member from a surface of the base member opposite the resin layer so as to suppress direct ablation of the resin layer due to the transfer laser, thereby causing heat generation at a surface of the structure in contact with the resin layer, and thermally decomposing at least a portion of the resin layer on an interface where the structure and the resin layer are in contact with each other.

That is, a transfer method of a first embodiment of the present invention is a transfer method for transferring a structure to a transfer destination, the transfer method including:
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the transfer destination by causing the transfer laser to be incident on the base member from a surface of the base member opposite the resin layer with such energy density that at least a portion of the resin layer remains on the base member.

In addition, a transfer method of a second embodiment of the present invention is a transfer method for transferring a structure to a transfer destination, the transfer method including:
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the transfer destination by causing a transfer laser to be incident on the base member from a surface of the base member opposite the resin layer with such energy density that at least a portion of the resin layer remains on the base member.

Further, a transfer method of a third embodiment of the present invention is a transfer method for transferring a structure to a transfer destination, the transfer method including:
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring of the structure from the release plate to the transfer destination.

Furthermore, a transfer unit of a first embodiment of the present invention is a transfer unit for transferring a structure to a transfer destination, the transfer unit including:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

In addition, a transfer unit of a second embodiment according to the present invention is a transfer unit for transferring a structure to a transfer destination, the transfer unit including:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is 0.1 µm or less;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

Further, a transfer unit of a third embodiment of the present invention is a transfer unit for transferring a structure to a transfer destination, the transfer method including:
a light source that oscillates a transfer laser;
a release plate including a base member, a resin layer provided on the base member, and a structure held on a surface of the resin layer opposite the base member; and
a controller configured to control oscillation of the transfer laser by the light source so that the transfer laser is to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the transfer destination.

Furthermore, a release plate of a first embodiment of the present invention is a release plate to be used for transferring a structure to a transfer destination by a transfer laser, the release plate including:
a base member;
a resin layer provided on the base member; and
a structure held on a surface of the resin layer opposite the base member, wherein
a holding thickness of a portion of the resin layer which is positioned between the base member and the structure is such that a transmittance for the transfer laser is 50% or more.

In addition, a release plate of a second embodiment of the present invention is a release plate to be used for transferring a structure to a transfer destination by a transfer laser, the release plate including:
a base member;
a resin layer provided on the base member; and
a structure held on a surface of the resin layer opposite the base member, wherein
a holding thickness of a portion of the resin layer which is positioned between the base member and the structure is 0.1 µm or less.

Further, a release-plate precursor substrate according to the present invention is a release-plate precursor substrate to be used for manufacturing a release plate for transferring a structure to a transfer destination by a transfer laser, the release-plate precursor substrate including:
a base member; and
a resin layer provided on the base member, wherein
a thickness of the resin layer is 0.4 µm or less.

Furthermore, a method for manufacturing a display apparatus of a first embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

In addition, a method for manufacturing a display apparatus of a second embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

Further, a method for manufacturing a display apparatus of a third embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

Furthermore, a method for manufacturing a mounted board of a first embodiment of the present invention is a method for manufacturing a mounted board, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

In addition, a method for manufacturing a mounted board of a second embodiment of the present invention is a method for manufacturing a mounted board, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

Further, a method for manufacturing a mounted board of a third embodiment of the present invention is a method for manufacturing a mounted board, wherein a structure is transferred to a wiring board, the method including:
providing the wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

Hereinafter, the present invention will be described in detail. However, the present invention is not limited thereto.

### [Transfer Unit]

### <First Embodiment>

The transfer unit of the first embodiment of the present invention is a transfer unit for transferring a structure to a transfer destination, the transfer unit including:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

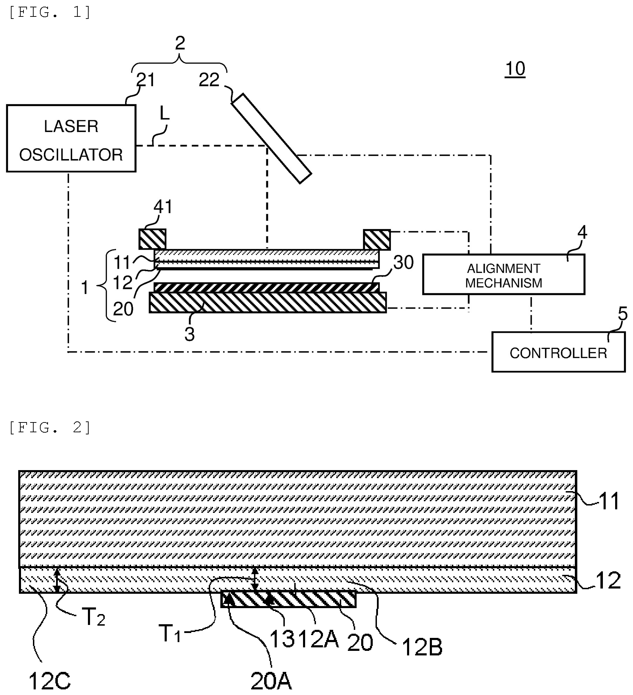

Hereinafter, an example of the transfer unit according to the first embodiment of the present invention will be described with reference to FIG. 1 to FIG. 3. However, the transfer unit according to the first embodiment of the present invention is not limited to the example shown in FIG. 1 to FIG. 3.

A transfer unit 10 shown in FIG. 1 is a transfer unit that transfers a structure 20 to a transfer destination 30.

The transfer unit 10 shown in FIG. 1 includes a light source 2, a release plate 1, a holding mechanism 3, an alignment mechanism 4, and a controller 5.

The light source 2 is configured to oscillate a transfer laser L. In the example in FIG. 1, the light source 2 includes a laser oscillator 21 that oscillates the transfer laser L and a mirror 22 that changes a direction of the laser oscillator 21, however, it is not limited to these configurations. For example, the light source 2 may include a galvano scanner provided with the mirror 22, a scanner that drives the mirror 22, and a controller that controls the mirror 22 and the scanner.

The laser oscillator 21 may pulse-oscillate the transfer laser L, or may continuously oscillate the transfer laser L. The laser oscillator 21 that pulse-oscillates the transfer laser L is preferable because it can irradiate only an appropriate part with the transfer laser of appropriate energy density.

The light source 2 may include a shaping optical system that shapes an energy distribution of the transfer laser L and/or a photomask that arranges an irradiation pattern, between the laser oscillator 21 and the release plate 1.

A wavelength of the transfer laser L is not limited in particular. The transfer laser L can be an excimer laser (a KrF excimer laser) having a wavelength of 248 nm, for example. In addition, examples include an ArF excimer laser (a wavelength of 193 nm), an XeCl excimer laser (a wavelength of 308 nm), and an XeF excimer laser (a wavelength of 353 nm), and the like. The KrF excimer laser is preferable from viewpoints of use performance and availability.

FIG. 2 is a schematic enlarged sectional view of a portion of the release plate 1 included in the transfer unit 10 shown in FIG. 1.

The release plate 1 includes a base member 11, a resin layer 12 provided on the base member 11, and the structure 20 held on a surface of the resin layer 12 opposite the base member 11. In the example in FIG. 1, the release plate 1 includes the plurality of structures 20.

The base member 11 is not limited in particular but may be made of quartz for example. A transmittance for the transfer laser L of the base member 11 is preferably 90% or more. However, as will be described in detail below, in the transfer unit 10 of the first embodiment of the present invention, a holding thickness T₁ of a portion 12B of the resin layer 12 which is positioned between the base member 11 and the structure 20 should be such that a transmittance for the transfer laser L is 50% or more, but the transmittance for the transfer laser L of the base member 11 is not limited in particular. When the transmittance for the transfer laser L of the base member 11 is 90% or more, attenuation in the base member layer 11 of the energy of the transfer laser L from the light source 2 can be suppressed, so that transfer with high energy efficiency is made possible.

A thickness of the base member 11 may be, for example, 0.1 mm or more and 1.0 mm or less, but is not limited in particular.

The holding thickness T₁ of the portion 12B of the resin layer 12 which is positioned between the base member 11 and the structure 20 is such that the transmittance for the transfer laser L is 50% or more. The transmittance for the transfer laser L of the portion 12B of the resin layer 12 may depend on, for example, the wavelength of the transfer laser L, a material and the holding thickness T₁ of the resin layer 12. The holding thickness T₁ is preferably such that the transmittance for the transfer laser is 70% or more. Here, the transmittance is a transmittance when the transfer laser L is perpendicularly incident on the surface of the resin layer 12, in other words, a transmittance in a thickness direction of the resin layer 12. This means that an absorptance for the transfer laser L of the resin layer 12 is less than 50%, and thus ablation of the resin layer 12 can be effectively suppressed or be made gentle. An upper limit of the transmittance is 100%, but may be about 90% or less from viewpoints of material availability and holding force securement.

The material of the resin layer 12 is not limited in particular, however, the resin layer 12 may contain, for example, polyimide, benzocyclobutene resin, or silicone-based resin.

The holding thickness T₁ of the resin layer 12 is preferably 0.1 µm or less for example, more preferably 0.06 µm or less. For example, the transmittance for the transfer laser L having the wavelength of 248 nm of a portion having the thickness of 0.1 µm of the resin layer 12 formed of polyimide is 55% or more. In addition, for example, the transmittance for the transfer laser L having the wavelength of 248 nm of a portion having the thickness of 0.05 µm of the resin layer 12 formed of polyimide is 74% or more.

In prior art, the material such as polyimide forming the resin layer 12 is designed such that the absorptance of the transfer laser is relatively large and the resin layer is strongly to be ablated for a purpose of positive ablation. Therefore, the ablation is not controlled, resulting in the problem described above, that is, the problem that a lot of residues deriving from the resin layer 12 remain in the structure after transfer. In addition, in prior art, lump-like residues sometimes scatter in disorder, making it difficult to remove the residues. The present inventors found that the ablation can be suppressed or made gentle by reducing the absorbed amount of a transfer laser by the resin layer at the portion (the portion 12B) holding the structure, even in a case of the resin layer 12 using the material with a high absorptance for the transfer laser causing such strong ablation. This can be realized by, for example, controlling the transmittance and the thickness of the resin layer at the portion (the portion 12B) holding the structure. It can be also realized by controlling the transmittance of the material used for the resin layer.

In the resin layer 12, as shown in FIG. 2, a region other than a region where the structure 13 is provided may include a portion 12C thicker than the holding thickness T₁. That is, a thickness T₂ of the portion 12C may be larger than the holding thickness T₁. Note that, in the transfer unit 10 of the present invention, the resin layer 12 may not include the portion 12C thicker than the holding thickness T₁. While there is a technology of pressurizing a structure provided on another substrate onto a release-plate precursor substrate and transferring it by a difference in adhesiveness in order to obtain a release plate having the structure, in such a case, the holding thickness T₁ is smaller than the thickness T₂ of the other portion.

The thickness T₂ of the portion 12C of the resin layer 12 is not limited in particular, but may be, for example, more than 0.1 µm and 0.4 µm or less.

Examples of a method for making the holding thickness T₁ smaller than the thickness T₂ of the portion 12C include a method of pressurizing the structure so as to push it into the resin layer when stacking the structure on the release-plate precursor substrate. By pressurizing it this way, only the thickness of the region where the structure is provided and around it can be selectively reduced. Depending on a shape and a size of the structure and magnitude and time of a pressure, for example, the holding thickness T₁ can be about two thirds to four fifth of the thickness T₂ of the portion 12C.

The structure 20 is an object to be transferred to be transferred to the transfer destination 30. The structure 20 is not limited in particular. For example, the structure 20 may be an LED chip such as a micro LED and a mini LED, or may be a semiconductor chip.

A constituent material of the structure 20 is not limited in particular, but a surface 20A of the structure 20 in contact with the resin layer 12 may contain gallium nitride (GaN) or gallium phosphide (GaP).

In the transfer unit 10 shown in FIG. 1, the release plate 1 is held by a holder 41.

The holding mechanism 3 is configured to hold the transfer destination 30.

The transfer destination 30 is not limited in particular as long as it can receive the structure 20. In the case where the structure 20 is an LED chip, the transfer destination 30 may be a wiring board of a display apparatus. Alternatively, in the case where the structure 20 is a semiconductor chip, the transfer destination 30 may be a wiring board of a mounted board.

Details of the holding mechanism 3 can be appropriately changed according to a shape or the like of the transfer destination 30. In the example in FIG. 1, the holding mechanism 3 is a stage that mounts and holds the transfer destination 30.

The alignment mechanism 4 is configured to make the light source 2 and the holding mechanism 3 face each other with the release plate 1 interposed therebetween. Though not limited thereto, in the example of the transfer unit 10 shown in FIG. 1, the alignment mechanism 4 includes the holder 41 that holds the release plate 1, a mechanism (not shown) that positions each member of the light source 2, and a mechanism (not shown) that positions the holding mechanism 3.

The controller 5 is configured to control oscillation of the transfer laser L by the light source 2. More specifically, the controller 5 is configured to control the oscillation of the transfer laser L by the light source 2 so as to cause the transfer laser L to be incident on the base member 11 from a surface of the base member 11 opposite the resin layer 12 with such energy density that at least a portion of the resin layer 12 remains on the base member 11.

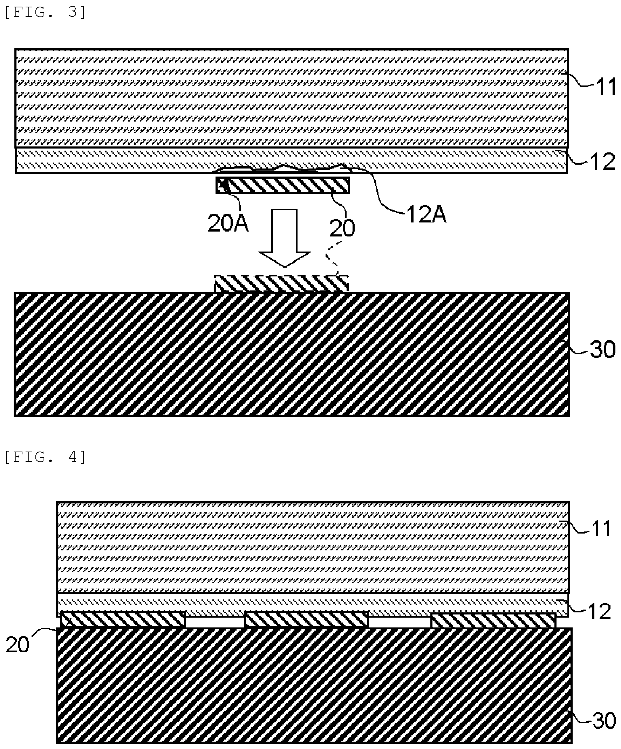

The transfer unit 10 of the first embodiment may transfer the structure 20 from the release plate 1 to the transfer destination 30 by thermally decomposing at least a portion 12A of the resin layer 12 on an interface 13 where the structure 20 and the resin layer 12 are in contact, as shown in FIG. 3 for example.

For example, in the transfer unit 10 of the first embodiment, the resin layer 12 may be thermally decomposed on the interface 13 by heat generation at the surface 20A of the structure 20 in contact with the resin layer 12 to a thermal decomposition temperature of the resin layer 12 or higher by virtue of the transfer laser L transmitted through the base member 11 and the resin layer 12. In addition, a vicinity of the interface of the structure 20 in contact with the resin layer 12 may contain a material with the high absorptance for the transfer laser L.

Other details of the transfer unit 10 will be described later.

By using such a transfer unit 10 of the first embodiment of the present invention, it is possible to execute the transfer method of the first embodiment of the present invention to be described in detail below. While detailed reasons will be described in the transfer method below, by using the transfer unit of the first embodiment of the present invention, it is possible to reduce residues deriving from the resin layer (the holding layer) 12 on the structure 20 after transfer.

Further, the release plate 1 provided in the transfer unit 10 of the first embodiment described above is the release plate of the first embodiment of the present invention. That is, the release plate 1 of the first embodiment of the present invention is used for transferring the structure 20 to the transfer destination 3 by the transfer laser L, and includes the base member 11, the resin layer 12 provided on the base member 11, and the structure 20 held on the surface of the resin layer 12 opposite the base member 11, and the holding thickness T₁ of the portion 12B of the resin layer 12 which is positioned between the base member 11 and the structure 20 is such that the transmittance for the transfer laser L is 50% or more.

### <Second Embodiment>

The transfer unit of the second embodiment of the present invention is a transfer unit for transferring a structure to a transfer destination, the transfer unit including:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is 0.1 µm or less;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

It can also be said that the transfer unit 10 described with reference to FIG. 1 to FIG. 3 is the transfer unit of the second embodiment of the present invention, in another aspect. More specifically, the transfer unit 10 shown in FIG. 1 to FIG. 3 includes the release plate 1 in which the holding thickness T₁ of the portion 12B of the resin layer 12 which is positioned between the base member 11 and the structure 20 is 0.1 µm or less.

The other details can be same as that of the transfer unit 10 of the first embodiment.

By using such a transfer unit 10 of the second embodiment of the present invention, it is possible to execute the transfer method of the second embodiment of the present invention to be described in detail below. While detailed reasons will be described in the transfer method below, by using the transfer unit of the second embodiment of the present invention, it is possible to reduce residues deriving from the resin layer (the holding layer) 12 on the structure 20 after transfer.

In addition, the release plate 1 included in the transfer unit 10 of the second embodiment described above is the release plate of the second embodiment of the present invention. That is, the release plate 1 of the second embodiment of the present invention is used for transferring the structure 20 to the transfer destination 3 by the transfer laser L, and includes the base member 11, the resin layer 12 provided on the base member 11, and the structure 20 held on the surface of the resin layer 12 opposite the base member 11, and the holding thickness T₁ of the portion 12B of the resin layer 12 which is positioned between the base member 11 and the structure 20 is 0.1 µm or less.

Note that such a release plate 1 of the second embodiment of the present invention can be manufactured by providing a release-plate precursor substrate including the base member 11 and the resin layer 12 provided on the base member 11, in which the thickness of the resin layer 12 is 0.4 µm or less; and making a surface 11 opposite the base member 11 of the resin layer 12 of the release-plate precursor substrate hold the structure 20. When the holding, the structure 20 is pressed to the resin layer 12 and the holding thickness T₁ of the portion 12B of the resin layer 12 which is positioned between the base member 11 and the structure 20 can be made to 0.1 µm or less. The release-plate precursor substrate used here is the release-plate precursor substrate of the present invention.

### <Third Embodiment>

The transfer unit of the third embodiment of the present invention is a transfer unit for transferring a structure to a transfer destination, the transfer method including:
a light source that oscillates a transfer laser;
a release plate including a base member, a resin layer provided on the base member, and a structure held on a surface of the resin layer opposite the base member; and
a controller configured to control oscillation of the transfer laser by the light source so that the transfer laser is to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the transfer destination.

It can also be said that the transfer unit 10 described with reference to FIG. 1 to FIG. 3 is the transfer unit of the third embodiment of the present invention, in another aspect. More specifically, the transfer unit 10 shown in FIG. 1 to FIG. 3 can include the controller 5 configured to control the oscillation of the transfer laser L by the light source 2 so that the transfer laser L is to be incident on the base member 11 from the surface of the base member 11 opposite the resin layer 12 so as to suppress direct ablation of the resin layer 12 due to the transfer laser, thereby causing heat generation at the surface 20A of the structure 20 in contact with the resin layer 12, thereby thermally decomposing at least a portion 12A of the resin layer 12 on the interface 13 where the structure 20 and the resin layer 12 are in contact with each other, resulting in transferring the structure 20 from the release plate 1 to the transfer destination 3.

The other details can be same as that of the transfer unit 10 of the first embodiment.

By using such a transfer unit 10 of the third embodiment of the present invention, it is possible to execute the transfer method of the third embodiment of the present invention to be described in detail below. While detailed reasons will be described in the transfer method below, it is possible to reduce residues deriving from the resin layer (the holding layer) 12 on the structure 20 after transfer.

### [Transfer Method]

### <First Embodiment>

The transfer method of the first embodiment of the present invention is a transfer method for transferring a structure to a transfer destination, the transfer method including:
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the transfer destination by causing the transfer laser to be incident on the base member from a surface of the base member opposite the resin layer with such energy density that at least a portion of the resin layer remains on the base member.

The transfer method of the first embodiment of the present invention can be performed using, for example, the transfer unit of the first embodiment of the present invention. However, the transfer method of the first embodiment of the present invention can be also performed in other apparatus or other units.

Hereinafter, the transfer method of the first embodiment of the present invention will be described with reference to FIG. 1 to FIG. 3 again.

First, the release plate 1 shown in FIG. 1 and FIG. 2, that is, the release plate 1 including the base member 11, the resin layer 12 provided on the base member 11, and the structure 20 held on the surface of the resin layer 12 opposite the base member 11, wherein the holding thickness T₁ of the portion 12B of the resin layer 20 which is positioned between the base member 11 and the structure 20 is such that the transmittance for the transfer laser L is 50% or more, is provided.

Next, the structure 20 is transferred from the release plate 1 to the transfer destination 3 by causing the transfer laser L to be incident on the base member 11 from the surface of the base member 11 opposite the resin layer 12 with such energy density that at least a portion of the resin layer 12 remains on the base member 11.

In this way, the structure 20 can be separated from the release plate 1 on the interface 13 of the resin layer 12 and the structure 20 by causing the transfer laser L to be incident on the base member 11 under conditions described above, for the release plate 1 in which the holding thickness T₁ of the portion 12B of the resin layer 12 which is positioned between the base member 11 and the structure 20 is such that the transmittance for the transfer laser L is 50% or more.

In prior art, the material such as polyimide forming the resin layer 12 is designed such that the absorptance of the transfer laser is relatively large and the resin layer is strongly to be ablated for the purpose of positive ablation. Therefore, the ablation is not controlled, resulting in the problem described above, that is, the problem that a lot of residues deriving from the resin layer 12 remain in the structure after transfer. In addition, in prior art, lump-like residues sometimes scatter in disorder, making it difficult to remove the residues. The present inventors found that the ablation can be suppressed or made gentle by reducing the absorbed amount of the transfer laser by the resin layer at the portion (the portion 12B) holding the structure, even in a case of the resin layer 12 using the material with a high absorptance for the transfer laser causing such strong ablation. This can be realized by, for example, controlling the transmittance and the thickness of the resin layer at the portion (the portion 12B) holding the structure. It can be also realized by controlling the transmittance of the material used for the resin layer.

According to the transfer method of the present invention, as described above, it is possible to reduce residues deriving from the resin layer (the holding layer) 12 on the structure 20 after transfer.

In addition, according to the transfer method of the first embodiment of the present invention, it is possible to transfer the structure 20 to the transfer destination 30 with high accuracy.

Such energy density that at least a portion of the resin layer 12 remains on the base member 11 may depend on, for example, the material and the holding thickness T₁ of the resin layer 12, the material of the surface 20A of the structure 20 in contact with the resin layer 12, and the wavelength of the transfer laser L.

For example, in the case where the resin layer 12 is formed of polyimide, the holding thickness T₁ is 0.1 µm, and the surface 20A of the structure 20 in contact with the resin layer 12 is gallium nitride, by performing irradiation with the transfer laser L having the wavelength of 248 nm with the energy density in a range of 1000 mJ/cm² to 3000 mJ/cm², the structure 20 can be separated from the release plate 1 in a state where at least a portion of the resin layer 12 remains on the base member 11, more specifically on the interface 13 of the resin layer 12 and the structure 20. Note that the irradiation may be performed separately in multiple times (for example, five to ten times), and in the case of performing the irradiation with 1000 mJ/cm² in ten times, it is 100 mJ/cm² × 10.

In addition, in the case where the resin layer 12 is formed of polyimide, the holding thickness T₁ is 0.06 µm, and the surface 20A of the structure 20 in contact with the resin layer 12 is gallium nitride, by performing the irradiation with the transfer laser L having the wavelength of 248 nm with the energy density in the range of 1000 mJ/cm² to 2000 mJ/cm², the structure 20 can be separated from the release plate 1 in the state where at least a portion of the resin layer 12 remains on the base member 11, more specifically on the interface 13 of the resin layer 12 and the structure 20.

Further, in the case where the resin layer 12 is formed of polyimide, the holding thickness T₁ is 0.1 µm, and the surface 20A of the structure 20 in contact with the resin layer 12 is gallium phosphide, by performing the irradiation with the transfer laser L having the wavelength of 248 nm with the energy density in the range of 1000 mJ/cm² to 3000 mJ/cm², the structure 20 can be separated from the release plate 1 in the state where at least a portion of the resin layer 12 remains on the base member 11, more specifically on the interface 13 of the resin layer 12 and the structure 20.

Furthermore, in the case where the resin layer 12 is formed of polyimide, the holding thickness T₁ is 0.06 µm, and the surface 20A of the structure 20 in contact with the resin layer 12 is gallium phosphide, by performing the irradiation with the transfer laser L having the wavelength of 248 nm with the energy density in the range of 1000 mJ/cm² to 2000 mJ/cm², the structure 20 can be separated from the release plate 1 in the state where at least a portion of the resin layer 12 remains on the base member 11, more specifically on the interface 13 of the resin layer 12 and the structure 20.

Moreover, in the case where the resin layer 12 is formed of polycyclobutene resin, the holding thickness T₁ is 0.1 µm, and the surface 20A of the structure 20 in contact with the resin layer 12 is gallium nitride, by performing the irradiation with the transfer laser L having the wavelength of 248 nm with the energy density in the range of 1000 mJ/cm² to 3000 mJ/cm², the structure 20 can be separated from the release plate 1 in the state where at least a portion of the resin layer 12 remains on the base member 11, more specifically on the interface 13 of the resin layer 12 and the structure 20.

In addition, in the case where the resin layer 12 is formed of polycyclobutene resin, the holding thickness T₁ is 0.06 µm, and the surface 20A of the structure 20 in contact with the resin layer 12 is gallium nitride, by performing the irradiation with the transfer laser L having the wavelength of 248 nm with the energy density in the range of 1000 mJ/cm² to 2000 mJ/cm², the structure 20 can be separated from the release plate 1 in the state where at least a portion of the resin layer 12 remains on the base member 11, more specifically on the interface 13 of the resin layer 12 and the structure 20.

Further, in the case where the resin layer 12 is formed of polycyclobutene resin, the holding thickness T₁ is 0.1 µm, and the surface 20A of the structure 20 in contact with the resin layer 12 is gallium phosphide, by performing the irradiation with the transfer laser L having the wavelength of 248 nm with the energy density in the range of 1000 mJ/cm² to 3000 mJ/cm², the structure 20 can be separated from the release plate 1 in the state where at least a portion of the resin layer 12 remains on the base member 11, more specifically on the interface 13 of the resin layer 12 and the structure 20.

Moreover, in the case where the resin layer 12 is formed of polycyclobutene resin, the holding thickness T₁ is 0.06 µm, and the surface 20A of the structure 20 in contact with the resin layer 12 is gallium phosphide, by performing the irradiation with the transfer laser L having the wavelength of 248 nm with the energy density in the range of 1000 mJ/cm² to 2000 mJ/cm², the structure 20 can be separated from the release plate 1 in the state where at least a portion of the resin layer 12 remains on the base member 11, more specifically on the interface 13 of the resin layer 12 and the structure 20.

According to the first transfer method of the present invention, for example, the surface 20A of the structure 20 can absorb the irradiation with the transfer laser L and generate heat. The surface 20A of the structure 20 can be the thermal decomposition temperature of the resin layer 12 or higher. The heat thus generated can thermally decompose the portion 12A of the resin layer 12 forming the interface 13.

That is, according to the transfer method of the first embodiment of the present invention, for example, it is possible to thermally decompose at least the portion 12A of the resin layer 12 on the interface 13 where the structure 20 and the resin layer 12 are in contact with each other. By virtue of this thermal decomposition, the structure 20 is separated on the interface 13 where the structure 20 and the resin layer 12 are in contact with each other, and the structure 20 can be transferred from the release plate 1 to the transfer destination 3.

### <Second Embodiment>

The transfer method of the second embodiment of the present invention is a transfer method for transferring a structure to a transfer destination, the transfer method including:
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the transfer destination by causing a transfer laser to be incident on the base member from a surface of the base member opposite the resin layer with such energy density that at least a portion of the resin layer remains on the base member.

The transfer method of the second embodiment of the present invention can be performed using, for example, the transfer unit of the second embodiment of the present invention. However, the transfer method of the second embodiment of the present invention can also be performed in other apparatus or other units.

Hereinafter, the transfer method of the second embodiment of the present invention will be described with reference to FIG. 1 to FIG. 3 again.

First, the release plate 1 shown in FIG. 1 and FIG. 2, that is, the release plate 1 including the base member 11, the resin layer 12 provided on the base member 11, and the structure 20 held on the surface of the resin layer 12 opposite the base member 11, wherein the holding thickness T₁ of the portion 12B of the resin layer 12 which is positioned between the base member 11 and the structure 20 is 0.1 µm or less, is provided.

Irradiation conditions of the transfer laser L are same as the conditions in the first embodiment.

The structure 20 can be separated from the release plate 1 on the interface 13 of the resin layer 12 and the structure 20 by thus causing the transfer laser L to be incident on the base member 11 under the conditions described above, for the release plate 1 in which the holding thickness T₁ of the portion 12B of the resin layer 12 which is positioned between the base member 11 and the structure 20 is 0.1 µm.

Thus, according to the transfer method of the second embodiment of the present invention, it is possible to reduce residues deriving from the resin layer (the holding layer) 12 on the structure 20 after transfer for the same reasons as that of the transfer method of the first embodiment. In addition, according to the transfer method of the second embodiment of the present invention, it is possible to transfer the structure 20 to the transfer destination 30 with high accuracy.

### <Third Embodiment>

The transfer method of the third embodiment of the present invention is a transfer method for transferring a structure to a transfer destination, the transfer method including:
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring of the structure from the release plate to the transfer destination.

The transfer method of the third embodiment of the present invention can be performed using, for example, the transfer unit of the third embodiment of the present invention. However, the transfer method of the third embodiment of the present invention can also be performed in other apparatus or other units.

Hereinafter, the transfer method of the third embodiment of the present invention will be described with reference to FIG. 1 to FIG. 3 again.

First, the release plate 1 shown in FIG. 1 and FIG. 2, that is, the release plate 1 including the base member 11, the resin layer 12 provided on the base member 11, and the structure 20 held on the surface of the resin layer 12 opposite the base member 11 is provided.

Next, the transfer laser L is caused to be incident on the base member 11 from the surface of the base member 11 opposite the resin layer 12 so as to suppress the direct ablation of the resin layer 12 by the transfer laser L, thereby causing heat generation at the surface of the structure 20 in contact with the resin layer 12, thereby thermally decomposing at least a portion of the resin layer 12 on the interface 13 where the structure 20 and the resin layer 12 are in contact with each other, resulting in transferring of the structure 20 from the release plate 1 to the transfer destination.

The structure 20 can be separated from the release plate 1 on the interface 13 of the resin layer 12 and the structure 20 by thus causing the transfer laser L to be incident on the base member 11 under the conditions described above, for the release plate 1 including the base member 11, the resin layer 12, and the structure 20.

Thus, according to the transfer method of the third embodiment of the present invention, it is possible to reduce residues deriving from the resin layer (the holding layer) 12 on the structure 20 after transfer for the same reasons as that of the transfer method of the first embodiment. In addition, according to the transfer method of the third embodiment of the present invention, it is possible to transfer the structure 20 to the transfer destination 30 with high accuracy.

Hereinafter, optional matters in the transfer method and the transfer unit of the present invention will be described.

For example, in the present invention, the resin layer 12 can be thermally decomposed on the interface 13 by heating the surface 20A of the structure 20 in contact with the resin layer 12 to the thermal decomposition temperature of the resin layer 12 or higher by virtue of the transfer laser L transmitted through the base member 11 and the resin layer 12.

When the thermal decomposition temperature of the constituent material of the surface 20A of the structure 20 in contact with the resin layer 12 is higher than the thermal decomposition temperature of the resin layer 12, it is possible to perform transfer while preventing degradation of the structure 20.

In particular, when the thermal decomposition temperature of the constituent material of the surface 20A of the structure 20 in contact with the resin layer 12 is higher than the thermal decomposition temperature of the resin layer 12 by 200 °C or more, it is possible to more reliably prevent the degradation of the structure 20. An upper limit of a difference in the thermal decomposition temperature is not limited in particular, but can be about 500 °C for example.

Note that, in the case where the surface 20A of the structure 20 in contact with the resin layer 12 becomes an easily removable thin film by the thermal decomposition, the heat generation at the surface 20A of the structure 20 in contact with the resin layer 12 to a temperature equal to or higher than the thermal decomposition temperature may be caused. For example, in the case where the material of the structure 20 is gallium nitride, since significant thermal decomposition is caused by heat generation of 900 °C or more to generate a gallium metal film, the gallium metal film can be removed with acid aqueous solution such as hydrochloric acid. Note that removal not only with the acid aqueous solution but with alkaline aqueous solution can be employed according to solubility of the thin film to be generated. In this way, it is possible to reduce restrictions of the material to be used in the structure 20 and the material to be used in the resin layer 12, and to employ more combinations.

For example, the resin layer 12 may contain polyimide, and the surface 20A of the structure 20 in contact with the resin layer 12 may contain gallium nitride.

Such a material combination is suitable when the wavelength of the transfer laser L is 248 nm.

As another embodiment, for example, the resin layer 12 may contain polyimide, and the surface 20A of the structure 20 in contact with the resin layer 12 may contain gallium phosphide.

As another embodiment, for example, the resin layer 12 may contain benzocyclobutene, and the surface 20A of the structure 20 in contact with the resin layer 12 may contain gallium phosphide.

Note that the example shown in FIG. 1 to FIG. 3 illustrates an example in which the release plate 1 and the transfer destination 30 are away from each other with a gap, that is, gap LIFT. In the transfer method and the transfer unit of the present invention, even when the gap is 300 µm for example, it is possible to transfer the structure 20 with high accuracy while reducing residues deriving from the resin layer (the holding layer) 12 on the structure 20 after transfer.

Alternatively, in the transfer method and the transfer unit 1 of the present invention, as shown in FIG. 4 for example, the release plate 1 and the transfer destination 30 may also be arranged in the state where the structure 20 is in contact with the transfer destination 30. The LIFT performed in such a state may be referred to as contact LIFT for example. When the transfer method of the present invention is the contact LIFT, it is possible to transfer the structure 20 with higher accuracy.

Moreover, in the transfer method and the transfer unit of the present invention, for example, the thickness of the resin layer 12 can be reduced, and an initial speed of movement of the structure 20 from the release plate 1 to the transfer destination 3 can be suppressed. As a result, it is possible to perform transfer while suppressing damages of the structure 20 even when it is the gap LIFT, even when adhesiveness and a cushioning property of a receiving surface of the transfer destination 3 are low, or even when the structure 20 is prone to be damaged (is big or has a level difference) further.

In addition, the gap LIFT is useful when transferring devices of various heights to the transfer destination 3 as the structure 20.

Note that, according to the transfer method of the present invention, the ablation of the resin layer 12 can be minimized compared to prior art. In other words, the thermal decomposition of the resin layer 12 can be concentrated in the vicinity of the interface with the structure 20. Therefore, it becomes easy to reduce residues deriving from the resin layer 12 at the transfer destination 30. In addition, in the case where the structure 20 is an LED chip and its surface in contact with the resin layer 12 is a light emitting surface, it is important to suppress generation of the residues and carbon-based debris.

The inventors found that, when the transmittance of a resin layer between a structure and a release plate base member is low, relatively strong ablation occurs and residues and their lumps are likely to be generated. Then, the inventors found that, by increasing the transmittance, the ablation can be made gentle and the residues and the lumps due to the strong ablation can be reduced. Specifically, by controlling the transmittance, it becomes easy to control a location in the thickness direction where the ablation occurs. For example, when the transmittance is around 40%, the ablation may occur at a depth in the middle of the thickness direction. At that time, a portion of the resin layer remains on a transferred chip side. However, since the ablation is controlled, residue lumps are suppressed. That is, it is conceivable that remaining resin has become a thin film by virtue of the control of the ablation. Such a thin film is easier to be removed than the residue lumps, and is removable, for example, by treatment of laser irradiation, etching such as wet etching and dry etching, and the like. From this, when the transmittance is 40% or more, even though an effect of the thermal decomposition is relatively small, residues are easily removed after transfer.

When the transmittance is 60% or more, the thermal decomposition as described above can be expected. In addition, in order to increase the transmittance, it is effective to reduce the thickness of the resin layer. Specifically, in the case of the thickness of 0.1 µm or less, the energy density of the laser for the irradiation can be reduced, and a large portion of the resin are easily removed. It is conceivable that such removal is realized by the thermal decomposition, the gentle ablation, or the combination thereof. Further, an absolute amount of the resin becomes small when the resin layer is thin, and it is also considered to contribute to reduction of residues. Therefore, the energy density does not need to be such that at least a portion of the resin layer remains on the base member, and a large portion of the resin layer may be removed by the thermal decomposition, the gentle ablation, or the combination thereof. From such a viewpoint, the thickness of the resin layer provided on the release-plate precursor substrate is preferably 0.2 µm or less, more preferably 0.1 µm or less, especially preferably 0.09 µm or less, greatly preferably 0.07 µm or less, extremely preferably 0.06 µm or less. This lower limit is not limited in particular, but is about 0.01 µm or 0.02 µm from the viewpoints of retention for the structure and formation of the resin layer.

### [Method for Manufacturing Display Apparatus and Method for Manufacturing Mounted Board]

The method for manufacturing the display apparatus of the first embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

In other words, it can also be said that the method for manufacturing the display apparatus of the first embodiment of the present invention is the method for manufacturing that includes a method for transferring the structure to the wiring board wherein the wiring board is used as the transfer destination in the transfer method of the first embodiment of the present invention.

According to such a method for manufacturing the display apparatus according to the first embodiment of the present invention, it is possible to manufacture the display apparatus wherein the structures with reduced residues are arranged on the wiring board, for the previously described reasons.

In addition, the method for manufacturing the display apparatus of the second embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

In other words, it can also be said that the method for manufacturing the display apparatus of the second embodiment of the present invention is the method for manufacturing that includes the method for transferring the structure to the wiring board wherein the wiring board is used as the transfer destination in the transfer method of the second embodiment of the present invention.

According to such a method for manufacturing the display apparatus according to the second embodiment of the present invention, it is possible to manufacture the display apparatus wherein the structures with reduced residues are arranged on the wiring board, for the previously described reasons.

Further, the method for manufacturing the display apparatus of the third embodiment of the present invention is a method for manufacturing a display apparatus, wherein a structure is transferred to a wiring board, the method including:
providing a wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

In other words, it can also be said that the method for manufacturing the display apparatus of the third embodiment of the present invention is the method for manufacturing that includes the method for transferring the structure to the wiring board wherein the wiring board is used as the transfer destination in the transfer method of the third embodiment of the present invention.

According to such a method for manufacturing the display apparatus according to the third embodiment of the present invention, it is possible to manufacture the display apparatus wherein the structures with reduced residues are arranged on the wiring board, for the previously described reasons.

Moreover, the method for manufacturing the mounted board of the first embodiment of the present invention is a method for manufacturing a mounted board, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

In other words, it can also be said that the method for manufacturing the mounted board of the first embodiment of the present invention is the method for manufacturing that includes the method for transferring the structure to the wiring board wherein the wiring board is used as the transfer destination in the transfer method of the first embodiment of the present invention.

According to such a method for manufacturing the mounted board according to the first embodiment of the present invention, it is possible to manufacture the mounted board wherein the structures with reduced residues are arranged on the wiring board, for the previously described reasons.

In addition, the method for manufacturing the mounted board of the second embodiment of the present invention is a method for manufacturing a mounted board, wherein a structure is transferred to a wiring board, the method including:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

In other words, it can also be said that the method for manufacturing the mounted board of the second embodiment of the present invention is the method for manufacturing that includes the method for transferring the structure to the wiring board wherein the wiring board is used as the transfer destination in the transfer method of the second embodiment of the present invention.

According to such a method for manufacturing the mounted board according to the second embodiment of the present invention, it is possible to manufacture the mounted board wherein the structures with reduced residues are arranged on the wiring board, for the previously described reasons.

Further, the method for manufacturing the mounted board of the third embodiment of the present invention is a method for manufacturing a mounted board, wherein a structure is transferred to a wiring board, the method including:
providing the wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

In other words, it can also be said that the method for manufacturing the mounted board of the third embodiment of the present invention is the method for manufacturing that includes the method for transferring the structure to the wiring board wherein the wiring board is used as the transfer destination in the transfer method of the third embodiment of the present invention.

According to such a method for manufacturing the mounted board according to the third embodiment of the present invention, it is possible to manufacture the mounted board wherein the structures with reduced residues are arranged on the wiring board, for the previously described reasons.

### EXAMPLES

Hereinafter, the present invention will be specifically described with reference to Examples and Comparative Examples, however, the present invention is not limited thereto.

### (Example 1)

In Example 1, the structures 20 were transferred by the gap LIFT using the transfer unit 10 shown in FIG. 1 to FIG. 3.

As the release plate 1, a release plate including the base member 11 made of quartz, the resin layer 12 formed of polyimide and having the thickness of 0.2 µm, and 20 pieces of micro LED chips 20 held on the surface of the base member 11 opposite the resin layer 12 was provided. The surface 20A of each of the micro LED chips 20 in contact with the resin layer 12 contained gallium nitride. In addition, the holding thickness T₁ of the portion 12B of the resin layer 12 which is positioned between the base member 11 and the structure 20 was about 0.15 µm.

The light source 2 including the laser oscillator 21 capable of oscillating a pulse excimer laser having the wavelength of 248 nm as the transfer laser L was provided.

As the transfer destination 30, a donor plate for which a silicone resin layer was formed on the surface of a base member made of quartz was provided.

The transmittance for the transfer laser of the base member 11 L was 90% or more. In addition, the transmittance for the transfer laser L of the resin layer 12 of about 0.15 µm was about 40%.

In the thus-provided transfer unit, the irradiation of ten shots of 100 mJ/cm² was performed with the transfer laser L, using the alignment mechanism 4 and the controller 5. Thus, the transfer laser L was transmitted through the base member 11 and the resin layer 12, the micro LED chips 20 were irradiated with it, and the micro LED chips 20 were transferred from the release plate 1 to the transfer destination 30.

In Example 1, transfer to a target position was accurately performed. Further, when the release plate and the micro LED chips 20 after the transfer in Example 1 were observed, a portion of the resin layer 12 remained on the surfaces of the micro LED chips 20 and the base member 11.

From these results, it can be seen that the ablation occurred at the depth in the middle of the thickness direction in Example 1. At that time, a portion of the resin layer remained on the transferred chip side, however, since the ablation was controlled, residue lumps were suppressed. That is, it is conceivable that the remaining resin was turned to a thin film by virtue of the control of the ablation.

### (Example 2)

In Example 2, the structure 20 was transferred by the contact LIFT, using the transfer unit 10 shown in FIG. 1, FIG. 2, and FIG. 4.

As the release plate 1, a release plate including the base member 11 made of quartz, the resin layer 12 formed of polyimide and having the thickness of 0.05 µm, and 20 pieces of micro LED chips 20 held on the surface of the base member 11 opposite the resin layer 12 was provided. The surface 20A of each of the micro LED chips 20 in contact with the resin layer 12 contained gallium nitride.

The light source 2 including the laser oscillator 21 capable of oscillating a pulse excimer laser having the wavelength of 248 nm as the transfer laser L was provided.

As the transfer destination 30, a donor plate for which a silicone resin layer was formed on the surface of a base member made of quartz was provided.

The transmittance of the base member 11 for the transfer laser L was 90% or more. In addition, the transmittance for the transfer laser L of the resin layer 12 of about 0.05 µm was about 74%.

In the thus-provided transfer unit, the irradiation of ten shots of 150 mJ/cm² was performed with the transfer laser L, using the alignment mechanism 4 and the controller 5. Thus, the transfer laser L was transmitted through the base member 11 and the resin layer 12, the micro LED chips 20 were irradiated with it, and the micro LED chips 20 were transferred from the release plate 1 to the transfer destination 30.

In Example 2, transfer to a target position was accurately performed. Further, when the release plate and the micro LED chips 20 after the transfer in Example 1 were observed, the resin layer 12 was not recognized on the surfaces of the micro LED chips 20 and the base member 11. Moreover, residues were not recognized on the surfaces of the micro LED chips 20.

From these results, it is conceivable that a large portion of the resin layer was removed by the thermal decomposition, the gentle ablation, or the combination thereof in Example 2.

The present description includes the following embodiments.
[1] A transfer method for transferring a structure to a transfer destination, the transfer method comprising:
   providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
   transferring the structure from the release plate to the transfer destination by causing the transfer laser to be incident on the base member from a surface of the base member opposite the resin layer with such energy density that at least a portion of the resin layer remains on the base member.
[2] The transfer method according to [1], wherein the holding thickness of the resin layer is such that the transmittance for the transfer laser is 70% or more.
[3] The transfer method according to [1] or [2], wherein the holding thickness of the resin layer is 0.1 µm or less.
[4] The transfer method according to [2], wherein the holding thickness of the resin layer is 0.06 µm or less.
[5] The transfer method according to any one of [1] to [4], wherein a region other than a region where the structure is provided in the resin layer includes a portion thicker than the holding thickness.
[6] The transfer method according to [5], wherein a thickness of the thick portion is more than 0.1 µm and 0.4 µm or less.
[7] The transfer method according to any one of [1] to [6], wherein at least a portion of the resin layer is thermally decomposed on an interface where the structure and the resin layer are in contact with each other, thereby transferring the structure from the release plate to the transfer destination.
[8] The transfer method according to [7], wherein the resin layer is thermally decomposed on the interface by heat generation at a surface of the structure in contact with the resin layer to a thermal decomposition temperature of the resin layer or higher by virtue of the transfer laser transmitted through the base member and the resin layer.
[9] The transfer method according to any one of [1] to [8], wherein a thermal decomposition temperature of a constituent material of a surface of the structure in contact with the resin layer is higher than a thermal decomposition temperature of the resin layer.
[10] The transfer method according to any one of [1] to [9], wherein the thermal decomposition temperature of the constituent material of the surface of the structure in contact with the resin layer is higher than the thermal decomposition temperature of the resin layer by 200°C or more.
[11] The transfer method according to any one of [1] to [10], wherein the resin layer contains polyimide or benzocyclobutene resin.
[12] The transfer method according to any one of [1] to [11], wherein a surface of the structure in contact with the resin layer contains gallium nitride or gallium phosphide.
[13] The transfer method according to any one of [1] to [10], wherein the resin layer contains polyimide and the surface of the structure in contact with the resin layer contains gallium nitride.
[14] The transfer method according to any one of [1] to [10], wherein the resin layer contains polyimide and the surface of the structure in contact with the resin layer contains gallium phosphide.
[15] The transfer method according to any one of [1] to [10], wherein the resin layer contains benzocyclobutene resin and the surface of the structure in contact with the resin layer contains gallium phosphide.
[16] The transfer method according to any one of [1] to [15], wherein the transmittance for the transfer laser of the base member is 90% or more.
[17] The transfer method according to any one of [1] to [16], wherein the transfer laser is an excimer laser having a wavelength of 248 nm.
[18] A transfer method for transferring a structure to a transfer destination, the transfer method comprising:
   providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
   transferring the structure from the release plate to the transfer destination by causing a transfer laser to be incident on the base member from a surface of the base member opposite the resin layer with such energy density that at least a portion of the resin layer remains on the base member.
[19] The transfer method according to [18], wherein a transmittance for the transfer laser of the base member is 90% or more.
[20] A transfer method for transferring a structure to a transfer destination, the transfer method comprising:
   providing a release plate including a base member, a resin layer provided on the base member, and a structure held on a surface of the resin layer opposite the base member; and
   causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring of the structure from the release plate to the transfer destination.
[21] A transfer unit for transferring a structure to a transfer destination, the transfer unit comprising:
   a light source that oscillates a transfer laser;
   a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more;
   a holding mechanism configured to hold the transfer destination;
   an alignment mechanism configured to make the light source and the holding mechanism face each other with the release plate interposed therebetween; and
   a controller configured to control oscillation of the transfer laser by the light source so that the transfer laser is to be incident on the base member from a surface of the base member opposite the resin layer with such energy density that at least a portion of the resin layer remains on the base member.
[22] The transfer unit according to [21], wherein the holding thickness of the resin layer is such that the transmittance for the transfer laser is 70% or more.
[23] The transfer unit according to [21] or [22], wherein the holding thickness of the resin layer is 0.1 µm or less.
[24] The transfer unit according to [22], wherein the holding thickness of the resin layer is 0.06 µm or less.
[25] The transfer unit according to any one of [21] to [24], wherein a region other than a region where the structure is provided in the resin layer includes a portion thicker than the holding thickness.
[26] The transfer method according to [25], wherein a thickness of the thick portion is more than 0.1 µm and 0.4 µm or less.
[27] The transfer unit according to any one of [21] to [26], wherein at least a portion of the resin layer is thermally decomposed on an interface where the structure and the resin layer are in contact with each other, thereby transferring the structure from the release plate to the transfer destination.
[28] The transfer unit according to [27], wherein the resin layer is thermally decomposed on the interface by heat generation at a surface of the structure in contact with the resin layer to a thermal decomposition temperature of the resin layer or higher by virtue of the transfer laser transmitted through the base member and the resin layer.
[29] The transfer unit according to any one of [21] to [28], wherein a thermal decomposition temperature of a constituent material of a surface of the structure in contact with the resin layer is higher than a thermal decomposition temperature of the resin layer.
[30] The transfer unit according to any one of [21] to [28], wherein the thermal decomposition temperature of the constituent material of the surface of the structure in contact with the resin layer is higher than the thermal decomposition temperature of the resin layer by 200°C or more.
[31] The transfer unit according to any one of [21] to [30], wherein the resin layer contains polyimide or benzocyclobutene resin.
[32] The transfer unit according to any one of [21] to [31], wherein a surface of the structure in contact with the resin layer contains gallium nitride or gallium phosphide.
[33] The transfer unit according to any one of [21] to [30], wherein the resin layer contains polyimide and the surface of the structure in contact with the resin layer contains gallium nitride.
[34] The transfer unit according to any one of [21] to [30], wherein the resin layer contains benzocyclobutene resin and the surface of the structure in contact with the resin layer contains gallium phosphide.
[35] The transfer unit according to any one of [21] to [30], wherein the resin layer contains polyimide and the surface of the structure in contact with the resin layer contains gallium phosphide.
[36] The transfer unit according to any one of [21] to [35], wherein the transmittance for the transfer laser of the base member is 90% or more.
[37] The transfer unit according to any one of [21] to [36], wherein the light source oscillates an excimer laser having a wavelength of 248 nm.
[38] A transfer unit for transferring a structure to a transfer destination, the transfer unit comprising:
   a light source that oscillates a transfer laser;
   a release plate including a base member, a resin layer provided on the base member, and a structure held on a surface of the resin layer opposite the base member, wherein a holding thickness of a portion of the resin layer which is positioned between the base member and the structure is 0.1 µm or less;
   a holding mechanism configured to hold the transfer destination;
   an alignment mechanism configured to make the light source and the holding mechanism face each other with the release plate interposed therebetween; and
   a controller configured to control oscillation of the transfer laser by the light source so that the transfer laser is to be incident on the base member from a surface of the resin layer opposite the base member with such energy density that at least a portion of the resin layer remains on the base member.
[39] The transfer unit according to [38], wherein a transmittance for the transfer laser of the base member is 90% or more.
[40] A transfer unit for transferring a structure to a transfer destination, the transfer unit comprising:
   a light source that oscillates a transfer laser;
   a release plate including a base member, a resin layer provided on the base member, and a structure held on a surface of the resin layer opposite the base member; and
   a controller configured to control oscillation of the transfer laser by the light source so that the transfer laser is to be incident on the base member from a surface of the mase member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the transfer destination.
[41] A release plate to be used for transferring a structure to a transfer destination by a transfer laser, the release plate comprising:
   a base member;
   a resin layer provided on the base member; and
   a structure held on a surface of the resin layer opposite the base member, wherein
   a holding thickness of a portion of the resin layer which is positioned between the base member and the structure is such that a transmittance for the transfer laser is 50% or more.
[42] A release plate to be used for transferring a structure to a transfer destination by a transfer laser, the release plate comprising:
   a base member;
   a resin layer provided on the base member; and
   a structure held on a surface of the resin layer opposite the base member, wherein
   a holding thickness of a portion of the resin layer which is positioned between the base member and the structure is 0.1 µm or less.
[43] A release-plate precursor substrate to be used for manufacturing a release plate for transferring a structure to a transfer destination by a transfer laser, the release-plate precursor substrate comprising:
   a base member; and
   a resin layer provided on the base member, wherein
   a thickness of the resin layer is 0.4 µm or less.
[44] A method for manufacturing a display apparatus, wherein a structure is transferred to a wiring board, the method comprising:
   providing a wiring board;
   providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
   transferring the structure from the release plate to the wiring board by causing the transfer laser to be incident on the base member from a surface of the base member opposite side of the resin layer with such energy density that at least a portion of the resin layer remains on the base member.
[45] A method for manufacturing a display apparatus, wherein a structure is transferred to a wiring board, the method comprising:
   providing a wiring board;
   providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
   transferring the structure from the release plate to the wiring substrate by causing the transfer laser to be incident on the base member from a surface of the base member opposite the resin layer with such energy density that at least a portion of the resin layer remains on the base member.
[46] A method for manufacturing a display apparatus, wherein a structure is transferred to a wiring board, the method comprising:
   providing a wiring board;
   providing a release plate including a base member, a resin layer provided on the base member, and a structure held on a surface of the resin layer opposite the base member; and
   causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.
[47] A method for manufacturing a mounted board, wherein a structure is transferred to a wiring board, the method comprising:
   providing a wiring board;
   providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
   transferring the structure from the release plate to the wiring board by causing the transfer laser to be incident on the base member from a surface of the base member opposite the resin layer with such energy density that at least a portion of the resin layer remains on the base member.
[48] A method for manufacturing a mounted board, wherein a structure is transferred to a wiring board, the method comprising:
   providing a wiring board;
   providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
   transferring the structure from the release plate to the wiring board by causing the transfer laser to be incident on the base member from a surface of the base member opposite the resin layer with such energy density that at least a portion of the resin layer remains on the base member.
[49] A method for manufacturing a mounted board, wherein a structure is transferred to a wiring board, the method comprising:
   providing the wiring board;
   providing a release plate including a base member, a resin layer provided on the base member, and a structure held on a surface of the resin layer opposite the base member; and
   causing a transfer laser to be incident on the base member from a surface of the base material opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

The following embodiments are also included.
[A1] A transfer method for transferring a structure to a transfer destination, the transfer method comprising:
   providing a release plate including a base member, a resin layer provided on the base member, and a structure held on a surface of the resin layer opposite the base member, wherein a holding thickness of a portion of the resin layer which is such that a transmittance for a transfer laser is 40% or more (preferably 50% or more, more preferably 60% or more, and particularly preferably 70% or more); and
   transferring the structure from the release plate to the transfer destination by causing a transfer laser to be incident on the base member from a surface of the base member opposite the resin layer.
[A2] A transfer method for transferring a structure to a transfer destination, the transfer method comprising:
   providing a release plate including a base member, a resin layer provided on the base member, and a structure held on a surface of the resin layer opposite the base member, , wherein a holding thickness of a portion of the resin layer which is positioned between the base member and the structure is 0.15 µm or less (preferably 0.1 µm or less, more preferably 0.09 µm or less, particularly preferably 0.07 µm or less, and extremely preferably 0.06 µm or less); and
   transferring the structure from the release plate to the transfer destination by causing a transfer laser to be incident on the base member from a surface of the base member opposite the resin layer.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A transfer method for transferring a structure to a transfer destination, the transfer method comprising:
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the transfer destination by causing the transfer laser to be incident on the base member from a surface of the base member opposite the resin layer with such energy density that at least a portion of the resin layer remains on the base member.

2. The transfer method according to claim 1, wherein the holding thickness of the resin layer is such that the transmittance for the transfer laser is 70% or more.

3. The transfer method according to claim 1, wherein the holding thickness of the resin layer is 0.1 µm or less.

4. The transfer method according to claim 2, wherein the holding thickness of the resin layer is 0.06 µm or less.

5. The transfer method according to any one of claims 1 to 4, wherein a region other than a region where the structure is provided in the resin layer includes a portion thicker than the holding thickness.

6. The transfer method according to claim 5, wherein a thickness of the thick portion is more than 0.1 µm and 0.4 µm or less.

7. The transfer method according to any one of claims 1 to 4, wherein at least a portion of the resin layer is thermally decomposed on an interface where the structure and the resin layer are in contact with each other, thereby transferring the structure from the release plate to the transfer destination.

8. The transfer method according to claim 7, wherein the resin layer is thermally decomposed on the interface by heat generation at a surface of the structure in contact with the resin layer to a thermal decomposition temperature of the resin layer or higher by virtue of the transfer laser transmitted through the base member and the resin layer.

9. The transfer method according to any one of claims 1 to 4, wherein a thermal decomposition temperature of a constituent material of a surface of the structure in contact with the resin layer is higher than a thermal decomposition temperature of the resin layer.

10. The transfer method according to claim 9, wherein the thermal decomposition temperature of the constituent material of the surface of the structure in contact with the resin layer is higher than the thermal decomposition temperature of the resin layer by 200°C or more.

11. The transfer method according to any one of claims 1 to 4, wherein the resin layer contains polyimide or benzocyclobutene resin.

12. The transfer method according to any one of claims 1 to 4, wherein a surface of the structure in contact with the resin layer contains gallium nitride or gallium phosphide.

13. The transfer method according to claim 9, wherein the resin layer contains polyimide and the surface of the structure in contact with the resin layer contains gallium nitride.

14. The transfer method according to claim 9, wherein the resin layer contains polyimide and the surface of the structure in contact with the resin layer contains gallium phosphide.

15. The transfer method according to claim 9, wherein the resin layer contains benzocyclobutene resin and the surface of the structure in contact with the resin layer contains gallium phosphide.

16. The transfer method according to any one of claims 1 to 4, wherein the transmittance for the transfer laser of the base member is 90% or more.

17. The transfer method according to any one of claims 1 to 4, wherein the transfer laser is an excimer laser having a wavelength of 248 nm.

18. A transfer method for transferring a structure to a transfer destination, the transfer method comprising:
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the transfer destination by causing a transfer laser to be incident on the base member from a surface of the base member opposite the resin layer with such energy density that at least a portion of the resin layer remains on the base member.

19. The transfer method according to claim 18, wherein a transmittance for the transfer laser of the base member is 90% or more.

20. A transfer method for transferring a structure to a transfer destination, the transfer method comprising:
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring of the structure from the release plate to the transfer destination.

21. A transfer unit for transferring a structure to a transfer destination, the transfer unit comprising:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the base member opposite the resin layer with such energy density that at least a portion of the resin layer remains on the base member.

22. The transfer unit according to claim 21, wherein the holding thickness of the resin layer is such that the transmittance for the transfer laser is 70% or more.

23. The transfer unit according to claim 21, wherein the holding thickness of the resin layer is 0.1 µm or less.

24. The transfer unit according to claim 22, wherein the holding thickness of the resin layer is 0.06 µm or less.

25. The transfer unit according to any one of claims 21 to 24, wherein a region other than a region where the structure is provided in the resin layer includes a portion thicker than the holding thickness.

26. The transfer method according to claim 25, wherein a thickness of the thick portion is more than 0.1 µm and 0.4 µm or less.

27. The transfer unit according to any one of claims 21 to 24, wherein at least a portion of the resin layer is thermally decomposed on an interface where the structure and the resin layer are in contact with each other, thereby transferring the structure from the release plate to the transfer destination.

28. The transfer unit according to claim 23, wherein the resin layer is thermally decomposed on the interface by heat generation at a surface of the structure in contact with the resin layer to a thermal decomposition temperature of the resin layer or higher by virtue of the transfer laser transmitted through the base member and the resin layer.

29. The transfer unit according to any one of claims 21 to 24, wherein a thermal decomposition temperature of a constituent material of a surface of the structure in contact with the resin layer is higher than a thermal decomposition temperature of the resin layer.

30. The transfer unit according to claim 29, wherein the thermal decomposition temperature of the constituent material of the surface of the structure in contact with the resin layer is higher than the thermal decomposition temperature of the resin layer by 200°C or more.

31. The transfer unit according to any one of claims 21 to 24, wherein the resin layer contains polyimide or benzocyclobutene resin.

32. The transfer unit according to any one of claims 21 to 24, wherein a surface of the structure in contact with the resin layer contains gallium nitride or gallium phosphide.

33. The transfer unit according to claim 29, wherein the resin layer contains polyimide and the surface of the structure in contact with the resin layer contains gallium nitride.

34. The transfer unit according to claim 29, wherein the resin layer contains benzocyclobutene resin and the surface of the structure in contact with the resin layer contains gallium phosphide.

35. The transfer unit according to claim 29, wherein the resin layer contains polyimide and the surface of the structure in contact with the resin layer contains gallium phosphide.

36. The transfer unit according to any one of claims 21 to 24, wherein the transmittance for the transfer laser of the base member is 90% or more.

37. The transfer unit according to any one of claims 21 to 24, wherein the light source oscillates an excimer laser having a wavelength of 248 nm.

38. A transfer unit for transferring a structure to a transfer destination, the transfer unit comprising:
a light source that oscillates a transfer laser;
a release plate including a base member, a resin layer provided on the base member, and a structure held on a surface of the resin layer opposite the base member, wherein a holding thickness of a portion of the resin layer which is positioned between the base member and the structure is 0.1 µm or less;
a holding mechanism configured to hold the transfer destination;
an alignment mechanism configured to make the light source and the holding mechanism face each other with the release plate interposed therebetween; and
a controller configured to control oscillation of the transfer laser by the light source so that the transfer laser is to be incident on the base member from a surface of the resin layer opposite the base member with such energy density that at least a portion of the resin layer remains on the base member.

39. The transfer unit according to claim 38, wherein a transmittance for the transfer laser of the base member is 90% or more.

40. A transfer unit for transferring a structure to a transfer destination, the transfer unit comprising:
a light source that oscillates a transfer laser;
a release plate including a base member, a resin layer provided on the base member, and a structure held on a surface of the resin layer opposite the base member; and
a controller configured to control oscillation of the transfer laser by the light source so that the transfer laser is to be incident on the base member from a surface of the mase member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the transfer destination.

41. A release plate to be used for transferring a structure to a transfer destination by a transfer laser, the release plate comprising:
a base member;
a resin layer provided on the base member; and
a structure held on a surface of the resin layer opposite the base member, wherein
a holding thickness of a portion of the resin layer which is positioned between the base member and the structure is such that a transmittance for the transfer laser is 50% or more.

42. A release plate to be used for transferring a structure to a transfer destination by a transfer laser, the release plate comprising:
a base member;
a resin layer provided on the base member; and
a structure held on a surface of the resin layer opposite the base member, wherein
a holding thickness of a portion of the resin layer which is positioned between the base member and the structure is 0.1 µm or less.

43. A release-plate precursor substrate to be used for manufacturing a release plate for transferring a structure to a transfer destination by a transfer laser, the release-plate precursor substrate comprising:
a base member; and
a resin layer provided on the base member, wherein
a thickness of the resin layer is 0.4 µm or less.

44. A method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite side of the resin layer with such energy density that at least a portion of the resin layer remains on the base member.

45. A method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring substrate by causing the transfer laser to be incident on the base member from a surface of the base member opposite the resin layer with such energy density that at least a portion of the resin layer remains on the base member.

46. A method for manufacturing a display apparatus, wherein a structure is transferred to a wiring board, the method comprising:
providing a wiring board;
providing a release plate including a base member, a resin layer provided on the base member, and a structure held on a surface of the resin layer opposite the base member; and
causing a transfer laser to be incident on the base member from a surface of the base member opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.

47. A method for manufacturing a mounted board, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is such that a transmittance for a transfer laser is 50% or more; and
transferring the structure from the release plate to the wiring board by causing the transfer laser to be incident on the base member from a surface of the base member opposite the resin layer with such energy density that at least a portion of the resin layer remains on the base member.

48. A method for manufacturing a mounted board, wherein a structure is transferred to a wiring board, the method comprising:
providing a wiring board;
providing a release plate including a base member, a resin layer provided on the base member, and a structure held on a surface of the resin layer opposite the base member, wherein a holding thickness of a portion of the resin layer which is positioned between the base member and the structure is 0.1 µm or less; and
transferring the structure from the release plate to the wiring board by causing the transfer laser to be incident on the base member from a surface of the base member opposite the resin layer with such energy density that at least a portion of the resin layer remains on the base member.

49. A method for manufacturing a mounted board, wherein a structure is transferred to a wiring board, the method comprising:
providing the wiring board;
providing a release plate including a base member, a resin layer provided on the base member, and a structure held on a surface of the resin layer opposite the base member; and
causing a transfer laser to be incident on the base member from a surface of the base material opposite the resin layer so as to suppress direct ablation of the resin layer due to the transfer laser, thereby causing heat generation at a surface of the structure in contact with the resin layer, thereby thermally decomposing at least a portion of the resin layer on an interface where the structure and the resin layer are in contact with each other, resulting in transferring the structure from the release plate to the wiring board.
